# EUROPEAN PATENT APPLICATION

(11) **EP 1 014 428 A2**
(43) Date of publication of application: **28.06.2000**
(21) Application number: 99309388.9
(22) Date of filing: 24.11.1999
(51) Int. Cl.: H01L 21/02, H01L 27/105, H01L 21/8239

(54) **Integrated circuit capacitor**

(30) Priority: 14.12.1998 US 211995
(71) Applicant: Fairchild Semiconductor Corporation, South Portland, Maine 04106 (US)
(72) Inventor: Rapp, Karl, Los Gatos, California 95032 (US)
(74) Representative: Gill, David Alan

(57) **Abstract**

A capacitor (20a, 20b) on an integrated circuit (10) is formed in the area vertically coextensive with (underlying) the IC's interconnect wiring surface area (14). The same conventional processing steps used to form other circuit devices (e.g. transistor gate electrodes (52, 54, 70) and gate insulation) define the capacitor electrodes (38, 42) and dielectric layers. The large surface area (14) under the interconnect wiring makes large capacitance available, e.g. for on-chip power (charge) storage or filter capacitors.

## Description

This invention relates to capacitors on integrated circuits (ICs).

Integrated circuits often have IC capacitors using MOS transistor channel capacitance. These MOS structures provide limited capacitance for two reasons. First, capacitance per unit area is small. Second, limited die area is available. Capacitance size remains limited in part because both chip failure rates and production costs increase as chip area increases.

Limitations notwithstanding, certain ICs require large on-chip capacitance. For example, specialized ICs designed to operate without being physically connected to a power source must rely on an indirect power source such as radio frequency energy transmitted from a base station. Moreover, this power source may continuously replenish the on-chip capacitors. The capacitors may then provide a burst of power when required. Such an IC (or others) may also require large integrated filter capacitors. However, on-chip power storage or filter (or other large capacitance) capacitors have generally not been practical because large capacitance values consume excessive chip surface area.

One method of increasing on-chip capacitance while not increasing chip area is to use materials with a higher dielectric constant; however these materials may not be compatible with standard IC processes. Any deviation from a standard fabrication process undesirably increases manufacturing cost, and incurs reliability problems. Therefore the need exists to satisfy three interrelated design requirements. First, form large capacitors on chips (ICs). Second, form the capacitors using little or no additional chip area. Finally, reduce or eliminate additional processing steps so that standard IC processing can be used.

The present invention therefore seeks to provide for an integrated circuit capacitor exhibiting an advantage over known such capacitors.

According to one embodiment of the invention there is provided an integrated circuit including a substrate having a principal surface, one or more device areas defined on said substrate principal surface, an interconnect area laterally adjacent to said one or more device areas, and having one or more interconnects that electrically connect to said one or more device areas and overlie said interconnect area, and a capacitor, the capacitor comprising a first electrode overlying said substrate principal surface and vertically coextensive at least in part with the said interconnect area, a dielectric layer overlying said first electrode, and a second electrode overlying the said dielectric layer.

According to another embodiment of the invention there is provided a method of forming a capacitor on an integrated circuit having a substrate with a principal surface and with one or more device areas defined laterally on the said principal surface, an interconnect area being laterally adjacent to the said one or more device areas, the method comprising the steps of forming a first electrode overlying the said principal surface and vertically coextensive at least in part with said interconnect area, forming a dielectric layer overlying the said first electrode, and forming a second electrode overlying the said dielectric layer.

Integrated circuit chips having large numbers of logic circuits typically employ logic cell configurations that are placed in rows and interconnected using techniques involving computer programs. Such chips generally require a large chip surface area for the interconnect wiring. Thus a large chip surface area lies otherwise unused under a chip's interconnect areas.

This invention uses that area, vertically coextensive (e.g., under at least in part) with a chip's interconnect area, to form therein large capacitors. In addition to interconnect regions between rows of logic cells, the chip surface area under the so-called "random" interconnect wiring on other portions of the chip is also available. In one embodiment, a first polysilicon electrode layer is deposited to form a first capacitor electrode. A dielectric layer is then deposited overlying the first electrode. A second polysilicon electrode layer is deposited overlying the dielectric layer, followed by an overlying insulating layer. Finally, conventional device interconnects are formed overlying the insulating layer. In one embodiment, the polysilicon, dielectric, and insulating layers are those also used to define other conventional on-chip structures (e.g. floating gate and/or standard transistors) so that no additional processing steps are necessary to define the capacitors. Hence the capacitor layers and corresponding transistor gate structure layers are laterally coextensive, meaning that while they are not necessarily exactly physically aligned laterally, they are formed by the same process steps.

Advantageously the chip surface area used by these capacitors is thus "free" since it is already allocated to the overlying interconnects, and so is available at no additional cost in terms of chip surface area.

For ICs that include non-volatile memory components and require extensive interconnect wiring, the chip area employed for the wiring thereby provides double duty by allowing "interpoly" capacitors to be buried beneath the multilayer metal interconnect wiring. Application-specific non-volatile memories are one such application area since they usually contain large sections of digital logic employing extensive interconnect. Because VDD (power) and VSS (ground) wiring typically is interspersed in such interconnect, such distributed interpoly filter capacitors readily can be coupled to the VDD bus. In this manner, distributed filter capacitors with total size of e.g. many hundreds of picofarads can be realized with negligible increase in chip area and with no process change.

In some embodiments of the invention, capacitors formed underlying interconnect areas (buried) are electrically connected so as to increase total capacitance. Some embodiments also electrically connect one or more of the capacitors between the chip power supply terminals as filter capacitors. In still other embodiments the on-chip capacitance is large enough to store and filter a weak charge replenished by an external RF field, to power the IC.

The invention is described further hereinafter, by way of example only, with reference to the accompanying drawings, in which:
Fig. 1 is a plan view of part of a surface of an integrated circuit showing a position for a capacitor formed underlying integrated circuit device interconnect wiring; and
Fig. 2 shows a cross-sectional view of Fig. 1 taken along line A-A.

Integrated circuits (ICs) having extensive interconnect wiring require that a considerable chip surface area be devoted to that wiring. Likewise, ICs that require large capacitors also require a considerable chip surface area be used for the capacitors. This invention is directed to using the same vertically coextensive chip area for both the on-chip capacitors and interconnect wiring.

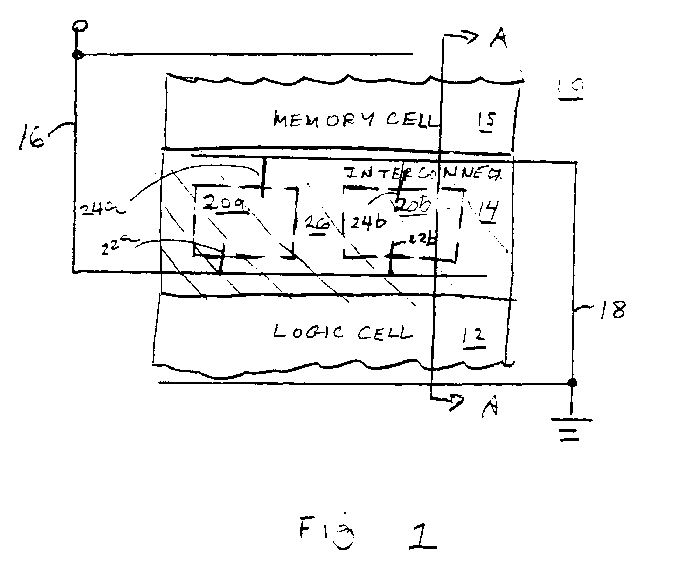

Fig. 1 is a plan view of a part of a surface of an integrated circuit showing, in accordance with an embodiment of the invention, a capacitor formed underlying integrated circuit device wiring. In this depiction, conventional device logic cell area 12 is shown positioned on an IC surface 10. An interconnect area 14 (hatched) is adjacent device cell area 12 (which conventionally includes a large number of transistors connected to form logic gates). Cell area 12 is e.g. a "standard cell" or other logic cell of the type well known in the IC field.

Conventional (e.g., multi-layer) IC interconnect wiring (not shown) occupies interconnect area 14 so as to conventionally electrically interconnect the device cell area 12 to other cells and/or to other integrated circuit devices (not shown). An optional conventional power bus area (VDD) 16 is shown (schematically) adjacent the device cell area 12. An optional conventional ground bus (VSS) 18 is also shown schematically. Power bus 16 and ground bus 18 conventionally provide respectively a power source and ground reference for circuit devices attached thereto. Also shown in FIG. 1 is a conventional memory (e.g. EEPROM or EPROM) cell area 15 positioned laterally to interconnect area 14. It is to be understood that the particular layout of FIG. 1 is only illustrative.

Two capacitor areas 20a and 20b (bounded by dashed lines) are shown within interconnect area 14. The dashed lines represent that capacitor areas 20a, 20b are located underneath the interconnect wiring (not shown) with respect to the IC substrate in interconnect area 14. Note that the present invention is applicable also to placing capacitors under other interconnect wiring regions, besides those between logic cell areas. Also shown are connections 22a and 22b between each capacitor area and power bus 16, and connections 24a and 24b between each capacitor area and ground bus 18. Connections 22a, 22b and 24a, 24b are to, respectively, the two electrodes of the capacitors in areas 20a, 20b. Area 26 between the two capacitor areas 20a and 20b represents an example of an area in which multi-level interconnect wiring (not shown) density precludes forming an underlying (buried) capacitor.

Those skilled in the art will understand that the area available to form such capacitors underlying interconnect wiring varies with the nature and extent of the wiring. Other embodiments may therefore allow more or less capacitor area than that shown in this depiction. Those skilled in the art will also realize that the capacitor is not limited to being formed between device cells such as cell areas 12 and 15. In other embodiments, the interconnect area under which the capacitors are located is at other regions of the chip, for instance under so-called "random" interconnect areas. Those skilled in the art will further recognize that in still other embodiments the power bus area 16 and ground bus area 18 are some common interdevice connection on the integrated circuit other than a power or ground source or reference, or are omitted entirely.

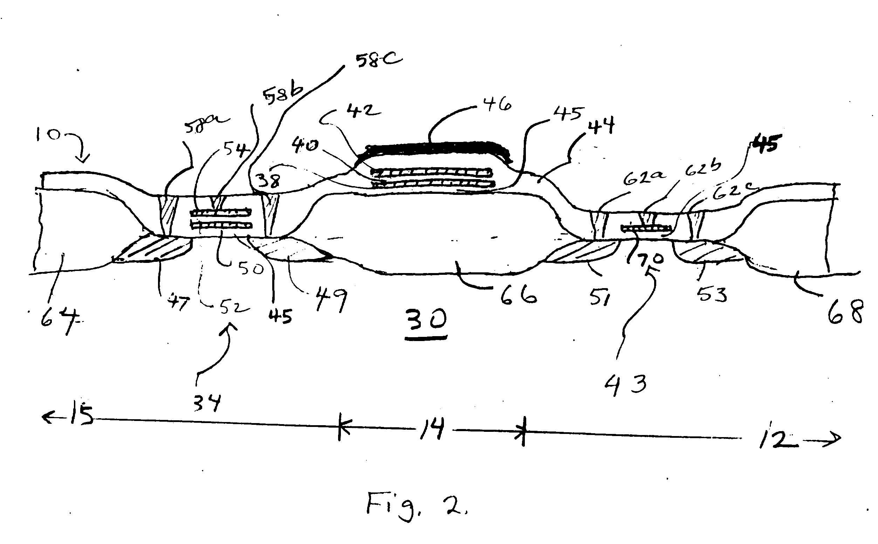

FIG. 2 shows a cross-section corresponding to portions of a capacitor and active devices intersected by cut line A-A in FIG. 1. Structures in FIG. 2 having the same reference numbers as in FIG. 1 refer to the same structures. One illustrative conventional floating gate transistor 34 is shown formed on IC substrate 30 (having surface 10) in cell area 15. The doped portions of transistor 34 (source/drain regions) in substrate 30 are 47, 49, respectively. The conventional source/drain and gate contacts are 58a, 58b, 58c.

A first (lower) planar capacitor electrode 38 is shown in interconnect area 14, overlaid by a dielectric layer 40. A second planar capacitor electrode 42 is shown overlying first electrode 38. An insulating layer 44 e.g. BPSG (borophosphosilicate glass) overlies second electrode 42, and a conductive interconnect layer 46 overlies insulating layer 44.

Conventional field oxide regions 64, 66,68 are present. FIG. 2 shows how the capacitor layers are formed by the same process steps as the corresponding (laterally coextensive) floating gate transistor 34 gate structure layers. Typically on an IC, such floating gate (dual gate) transistors as 34 are used in non-volatile memory (EPROM or EEPROM) cells. Other standard (single gate layer) logic transistors are formed in the same process steps but omit one gate electrode layer and the inter-gate dielectric layer. One such standard transistor 43 is depicted in FIG. 2 in logic cell area 12.

The composition of conventional gate oxide layer 45, capacitor electrodes 38 and 42, dielectric 40, insulating layer 44, and conductive interconnect 46 may vary. The embodiment shown has materials and structures compatible with those used to form IC MOS transistors, as discussed below. Hence these capacitors can be formed in the same conventional process steps as the gate structures of the transistors with which they are laterally coextensive, as in FIG. 2. Those skilled in the art will understand, however, that the capacitors may use many different compositions having desired electrical properties.

FIG. 2 thus illustrates in cross section both the buried capacitor and exemplary active circuit devices formed by the same conventional process steps. The sequence of steps is apparent to one of ordinary skill in the art. For example, the embodiment shown uses conventional doped polysilicon transistor gate electrode and dielectric layers to define the capacitor. As shown, the first capacitor electrode 38 is a polysilicon (polycrystalline silicon) layer formed in the same step(s) as is the floating gate electrode 50 which is a conventional polysilicon layer ("poly-1") in transistor 34. Similarly, a single deposited polysilicon layer ("poly-2") defines both second capacitor electrode 42 and conventional gate electrode 54.

Moreover, the same insulating layer defines dielectric layer 40 between electrodes 38 and 42, and corresponding inter-gate insulating layer 52 located between the two transistor gate electrodes 50 and 54. In one embodiment, layer 40 and 52 is conventional silicon dioxide (SiO₂). An alternative material for layer 40 and 52 is the well known "ONO" (silicon dioxide-silicon nitride-silicon dioxide) stack. An additional conventional SiO₂ or BPSG layer may then form layers 44 and 56.

The same process steps are used to form the standard logic (single gate electrode) transistor 43, but as shown one gate electrode and the "interpoly" (inter-gate) dielectric layer are omitted: Thus transistor 34 includes doped (source/drain) regions 51, 53, gate oxide layer 45, and gate electrode 70. Contacts 62a, 62b, 62c are conventional. Finally, a conductive layer such as aluminum is deposited and patterned to form both transistor contacts 58a, 58b, 58c and 60a, 60b, 60c and required wiring in interconnect area 32 as represented by conductive interconnect 46. (Of course, multiple interconnect wiring layers 46 may be present separated by intervening insulative layers.) Hence all process steps are conventional IC (e.g. CMOS) process steps, yet no extra process steps are required to form the capacitor. It is to be understood that the masks used in these fabrication steps to define the transistor structures are configured so as also to define the corresponding capacitor structures.

Those skilled in the art will understand that specific process steps may be added or modified as required to achieve specific design goals. For example, the extent of interconnect wiring in a particular chip area may limit placing possible capacitors in that area. Overall capacitance design requirements are also to be considered to determine the size and interconnection of individual capacitors accordingly. For example, several capacitors may be connected together to form an integrated filter capacitor. Interconnection of the capacitor electrodes to the desired portions of the IC circuits is conventional.

An additional benefit of forming capacitors vertically coextensive with large on-chip interconnect areas is cost savings since no additional chip area is needed for the capacitors, and chip cost is generally a function of surface area.

Those skilled in the art should realize that while the above description has shown and described particular embodiments, many changes and modifications may exist without departing from the invention's broader aspects. Therefore the scope of the following claims encompasses all changes and modifications that fall within the invention's true scope and spirit.

## Claims

1. An integrated circuit (10) including a substrate (30) having a principal surface, one or more device areas (12, 15) defined on said substrate principal surface, an interconnect area (14) laterally adjacent to said one or more device areas (12, 15) and having one or more interconnects (46) that electrically connect to said one or more device areas (12, 15) and overlie said interconnect area (14), and a capacitor (20a, 20b), the capacitor (20a, 20b) comprising:
a first electrode (38) overlying said substrate (30) principal surface and vertically coextensive at least in part with the said interconnect area (14);
a dielectric layer (40) overlying said first electrode; and
a second electrode (42) overlying the said dielectric layer.

2. An integrated circuit as claimed in Claim 1, wherein the said dielectric layer (40) includes at least one layer of silicon dioxide and one layer of nitride.

3. An integrated circuit as claimed in Claim 1 or 2, wherein at least one of the said first (38) and second (42) electrodes is formed of polycrystalline silicon.

4. An integrated circuit as claimed in Claim 1, 2 or 3, further comprising a common bus (16, 18), the said common bus (16, 18) being electrically coupled to either the said first (38) or the said second electrode (42) and electrically coupled to at least one circuit device (43, 34) formed in the said one or more device areas (12, 15).

5. An integrated circuit as claimed in Claim 1, 2, 3 or 4, wherein the said capacitor (20a, 20b) underlies the said one or more interconnects (46).

6. An integrated circuit as claimed in any one of the preceding claims, wherein the said first electrode (38), the dielectric layer (40) and the second electrode (42) are laterally coextensive with, respectively, a floating gate electrode layer (50), a dielectric layer (52), and a gate electrode layer (54) of a transistor (34) in one of the said device areas (15).

7. An integrated circuit as claimed in any one of the preceding claims, wherein the said second electrode (42) is laterally coextensive with a gate electrode layer (70) of a transistor (43) in one of the said device areas (12).

8. A method of forming a capacitor (20a, 20b) on an integrated circuit having a substrate (30) with a principal surface and with one or more device areas (12, 15) defined laterally on the said principal surface, an interconnect area (14) being laterally adjacent to the said one or more device areas (12, 15), the method comprising the steps of:
forming a first electrode (38) overlying the said principal surface and vertically coextensive at least in part with said interconnect area (14);
forming a dielectric layer (40) overlying the said first electrode (38); and
forming a second electrode (42) overlying the said dielectric layer (40).

9. A method as claimed in Claim 8, further comprising the step of:
forming one or more conducting interconnects (46) overlying said interconnect area (14).

10. A method as claimed in Claim 8 or 9, wherein forming the said first electrode (38) comprises forming a layer of polycrystalline silicon.

11. A method as claimed in Claim 8, 9 or 10, wherein forming the said second electrode comprises forming a layer of polycrystalline silicon.

12. A method as claimed in Claim 8, 9, 10 or 11, wherein forming the said dielectric layer comprises forming a layer of silicon dioxide and a layer of silicon nitride.

13. A method as claimed in any one of Claim 8 to 12, further comprising the step of:
forming a common bus (16, 18) overlying the said interconnect area (14), said common bus (16, 18) being electrically coupled to either said first (38) or said second (42) electrode and electrically coupled to at least one circuit device (43, 34) formed in the said one or more device areas (12, 15).

14. A method as claimed in any one of the preceding claims, wherein the said second electrode (42) is formed laterally coextensive with a gate electrode (54, 10) of a circuit device (34, 43) in one of the said device areas (15, 12).

15. A method as claimed in any one of the preceding claims, wherein the said first electrode (38) is formed laterally coextensive with a gate electrode (54, 70) of a circuit device (34, 43) in one of the said device areas (15, 12).
